# EUROPEAN PATENT APPLICATION

(11) **EP 2 154 570 A1**
(43) Date of publication of application: **17.02.2010**
(21) Application number: 08764962.0
(22) Date of filing: 27.05.2008
(51) Int. Cl.: G03F 7/027, C09J 4/02, C09J 7/02, C09J 11/04, C09J 163/00, G03F 7/004, H01L 21/027

(54) **PHOTOSENSITIVE ADHESIVE RESIN COMPOSITION, ADHESIVE FILM AND LIGHT-RECEIVING DEVICE**

(30) Priority: 30.05.2007 JP 2007142925; 19.05.2008 JP 2008130328
(71) Applicant: Sumitomo Bakelite Co., Ltd., Shinagawa-ku Tokyo 140-0002 (JP)
(72) Inventor: TAKAYAMA, Rie, Tokyo 140-0002 (JP); TAKAHASHI, Toyosei, Tokyo 140-0002 (JP)
(74) Representative: Müller-Boré & Partner Patentanwälte
(86) International application number: PCT/JP2008/060112
(87) International publication number: WO 2008/146936

(57) **Abstract**

A photosensitive adhesive resin composition includes (A) a compound having a hydroxyl group or a carboxyl group, and a (meth)acryloyl group, (B) a resin which cures with the compound (A) by thermal treatment, (C) a compound having a (meth)acryloyl group and not having a hydroxyl group and a carboxyl group, (D) a phenol resin or a phenol compound, and (E) a photoactive compound. The photosensitive adhesive resin composition has excellent developability, and is used for producing a spacer formed between a transparent substrate and a substrate on which a semiconductor element is formed. An adhesive film and a light-receiving device are produced using the photosensitive adhesive resin composition.

## Description

### TECHNICAL FIELD

The present invention relates to a photosensitive adhesive resin composition, an adhesive film, and a light-receiving device.

### BACKGROUND ART

A photosensitive film which can be bonded to a semiconductor wafer or the like, patterned by exposure and development, and bonded to a transparent substrate such as a glass substrate, has been desired (see Patent Document 1, for example). In this case, the patterned photosensitive film has behavior as a spacer between the semiconductor wafer and the transparent substrate.

A resin composition used to form a spacer must allow patterning by a photolithographic process, and maintain the shape of a spacer.

Since such a resin composition is exposed and developed, excellent developability is also required.
(Patent Document 1) JP-A-2006-323089 (claims 1 to 20)

An object of the present invention is to provide a photosensitive adhesive resin composition which has excellent developability and is used for producing a spacer disposed between a transparent substrate and a substrate on which a semiconductor element is formed, and an adhesive film using the photosensitive adhesive resin composition.

Another object of the present invention is to provide a light-receiving device in which a transparent substrate and a substrate on which a semiconductor element is formed are bonded via a spacer formed of a cured material of the above photosensitive adhesive resin composition.

### DISCLOSURE OF THE INVENTION

The above objects can be attained by the following technologies (1) to (12).
(1) A photosensitive adhesive resin composition comprising (A) a compound having a hydroxyl group or a carboxyl group, and a (meth)acryloyl group, (B) a resin which cures with the compound (A) by thermal treatment, (C) a compound having a (meth)acryloyl group and not having a hydroxyl group and a carboxyl group, (D) a phenol resin or a phenol compound, and (E) a photoactive compound.
(2) The photosensitive adhesive resin composition according to (1), wherein the compound (A) is a (meth)acryloyl-modified novolac phenol resin.
(3) The photosensitive adhesive resin composition according to (1), wherein the compound (A) is a (meth)acryloyl-modified bisphenol A shown by the following formula (1), 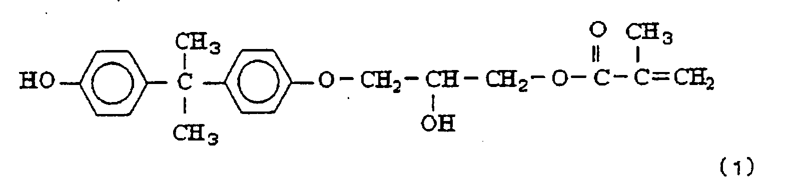 or 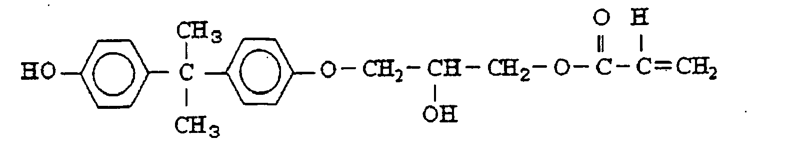 or a (meth)acryloyl-modified novolac bisphenol A resin obtained by substituting some of the hydroxyl groups of a novolac bisphenol A resin shown by the following formula (2) 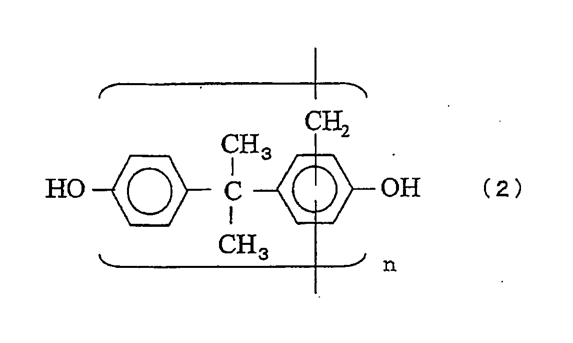 (wherein n is an integer from 2 to 15) with the group shown by the following formula (3). 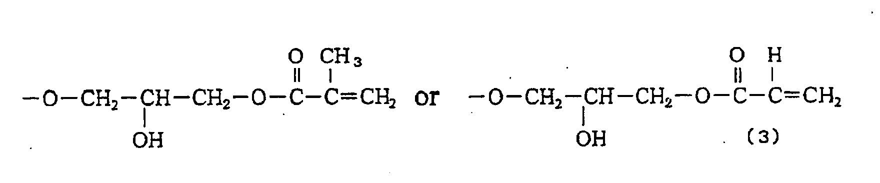
(4) The photosensitive adhesive resin composition according to any one of (1) to (3), wherein the content of the phenol resin or the phenol compound (D) is 0.1 to 20 mass%.
(5) The photosensitive adhesive resin composition according to any one of (1) to (4), wherein the phenol resin or the phenol compound (D) is a novolac phenol resin or phenol monomer.
(6) The photosensitive adhesive resin composition according to any one of (1) to (5), further comprising (F) a filler.
(7) The photosensitive adhesive resin composition according to (6), wherein the content of the filler (F) is 3 to 50 mass%.
(8) The photosensitive adhesive resin composition according to (6) or (7), wherein the average particle diameter of the filler (F) is 0.03 to 0.4 µm.
(9) The photosensitive adhesive resin composition according to any one of (6) to (8), wherein the filler (F) is a silica filler.
(10) The photosensitive adhesive resin composition according to any one of (1) to (9), wherein the resin (B) which cures with the compound (A) by thermal treatment is a combination of an epoxy resin which is solid at 25°C and a silicone-modified epoxy resin which is liquid at 25°C.
(11) An adhesive film comprising a base film and an adhesive layer formed on the surface of the base film, the adhesive layer being formed of the photosensitive adhesive resin composition according to any one of (1) to (10).
(12) A light-receiving device comprising a substrate on which a semiconductor element is formed, a transparent substrate facing the substrate, and a spacer formed between the transparent substrate and the substrate, the spacer being made of a cured material of the photosensitive adhesive resin composition according to any one of (1) to (11).

According to the present invention, a photosensitive adhesive resin composition which has excellent developability and is used for producing a spacer formed between a transparent substrate and a substrate on which a semiconductor element is formed, an adhesive film made of the photosensitive adhesive resin composition, and a light-receiving device can be provided.

According to the present invention, a light-receiving device in which a transparent substrate and a substrate on which a semiconductor element is formed are bonded via a spacer formed of a cured material of the above photosensitive adhesive resin composition can also be provided.

### BRIEF DESCRIPTION OF THE DRAWINGS

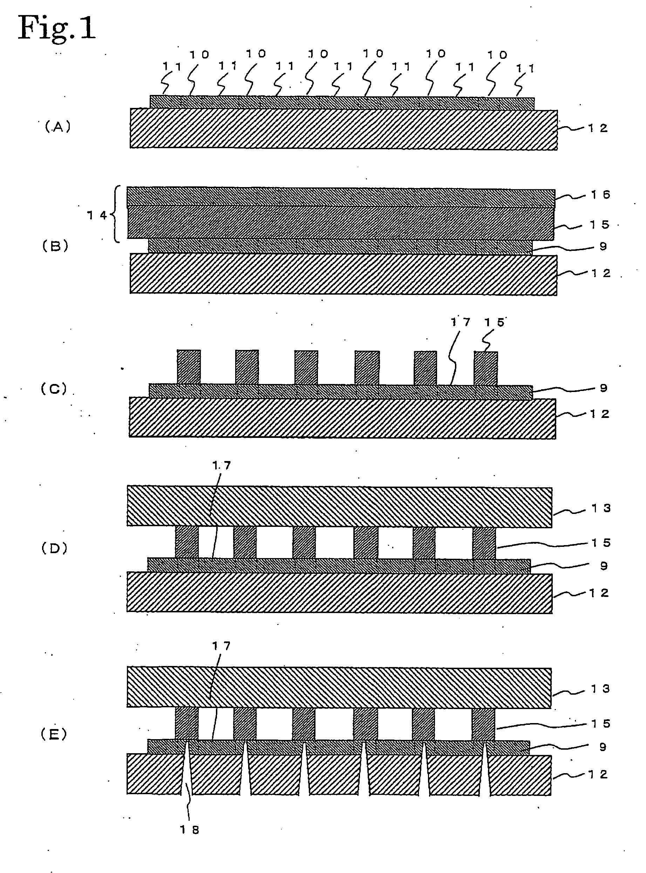

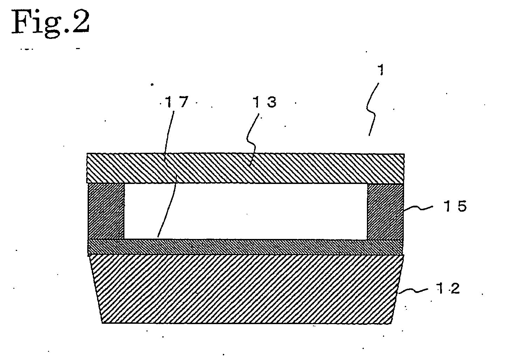

Fig. 1 is a schematic cross-sectional view showing one embodiment of a method for using an adhesive film of the present invention, and Fig. 2 is a schematic cross-sectional view showing a light-receiving device.

### BEST MODE FOR CURRYING OUT THE INVENTION

Preferred embodiments of a photosensitive adhesive resin composition, an adhesive film, and a light-receiving device of the present invention will now be described.

### 1. Photosensitive adhesive resin composition

A photosensitive adhesive resin composition of the present invention comprises (A) a resin having a hydroxyl group or a carboxyl group, and a (meth)acryloyl group (hereinafter may be referred to as "compound (A)"), (B) a resin which cures with the compound (A) by thermal treatment (hereinafter may be referred to as "compound (B)"), (C) a compound having a (meth)acryloyl group and not having a hydroxyl group and a carboxyl group (hereinafter may be referred to as "compound (C)"), (D) a phenol resin or a phenol compound (hereinafter may be referred to as "compound (D)"), and (E) a photoactive compound. Inclusion of the phenol resin or the phenol compound (D) improves the solubility and developability of the photosensitive adhesive resin composition in an alkaline developer after exposure.

The term "(meth)acryloyl group" used in the present invention means to an acryloyl group or a methacryloyl group. The acryloyl group is a group shown by the following formula.

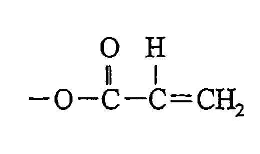

The methacryloyl group is a group shown by the following formula.

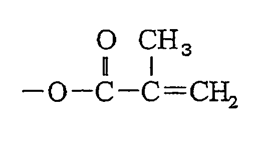

When the compound (A) is a (meth)acryloyl-modified novolac phenol resin, the photosensitive adhesive resin composition of the present invention exhibits better solubility and developability in an alkaline developer due to an increase in the amount of phenolic hydroxyl groups.

The compound (A) used in the present invention is a compound having a hydroxyl group or a carboxyl group, and a (meth)acryloyl group. There are no particular limitations to the compound (A) in as much as the compound is soluble in an alkaline developer, has a hydroxyl group or a carboxyl group which reacts with the compound (B), and has a (meth)acryloyl group which reacts by exposure to light and thermal treatment

The weight average molecular weight of the compound (A) is 200 to 7000, and preferably 300 to 5000. If the compound (A) has a weight average molecular weight within the above range, the compound (A) has good solubility in a developer so that the photosensitive adhesive resin composition has good developability. In the present invention, the weight average molecular weight is measured by gel permeation chromatography (GPC), and expressed by a polystyrene-corresponding value.

The number of hydroxyl groups or carboxyl groups in one molecule of the compound (A) is preferably 1 to 25, and particularly preferably 2 to 20. If the number of hydroxyl groups or carboxyl groups in one molecule of the compound (A) is within the above range, developability is better.

The ratio of the weight average molecular weight to the number of hydroxyl groups or carboxyl groups of the compound (A) is preferably 200 to 3500, and particularly preferably 300 to 2000. If the ratio of the weight average molecular weight to the number of hydroxyl groups or carboxyl groups of the compound (A) is within the above range, the compound (A) has good solubility in a developer so that the photosensitive adhesive resin composition has good developability.

The number of (meth)acryloyl groups in one molecule of the compound (A) is 1 to 40, and preferably 2 to 30. The number of (meth)acryloyl groups in one molecule of the compound (A) is within the above range, a cured product of the photosensitive adhesive resin composition has high heat resistance.

Specific examples of the compound (A) include a compound obtained by reacting a (meth)acryloyl-modified epoxy resin having a (meth)acryloyl group on each end with a dibasic acid. In this compound, a hydroxyl group in the molecular chain of the (meth)acryloyl-modified epoxy resin bonds to one of the carboxyl groups in the dibasic acid via an ester bond (the number of epoxy resin repeating units in the compound is one or more, and the number of dibasic acids introduced into the molecular chain is one or more). The above compound may be obtained by polymerizing epichlorohydrin and a polyhydric alcohol to produce an epoxy resin, reacting the epoxy groups on the ends of the epoxy resin with a (meth)acrylic acid to obtain a (meth)acryloyl-modified epoxy resin having a (meth)acryloyl group introduced into each end of the epoxy resin, and reacting a dibasic acid anhydride with a hydroxyl group in the molecular chain of the (meth)acryloyl-modified epoxy resin to form an ester bond with one of the carboxyl groups of the dibasic acid.

The compound (A) may be a (meth)acryloyl-modified bisphenol produced from a bisphenol compound and a compound having an epoxy group and a (meth)acryloyl group by reacting one of the hydroxyl groups of the bisphenol compound with the epoxy group of the compound having an epoxy group and a (meth)acryloyl group.

The compound (A) may also be a (meth)acrylic acid polymer having a carboxyl group and a (meth)acryloyl group (the number of (meth)acrylic acid repeating units is two or more).

Among these, the (meth)acryloyl-modified bisphenol, the (meth)acryloyl-modified novolac phenol resin, and the (meth)acrylic acid polymer having a carboxyl group and a (meth)acryloyl group, particularly the (meth)acryloyl-modified bisphenol and the (meth)acryloyl-modified novolac phenol resin are preferable, from the viewpoint of well-balanced developability of the photosensitive adhesive resin composition and the heat resistance of the cured material.

In the present invention, an acrylic acid copolymer having a carboxyl group and a (meth)acryloyl group refers to a compound obtained by substituting some of the acid groups (-COOH) of (meth)acrylic acid copolymer shown by the following formula (4) 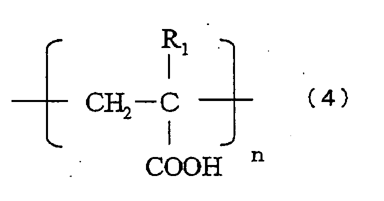 (wherein R₁ represents a hydrogen atom or a methyl group, and n represents an integer from 2 to 10) with a group shown by the following formula (5). 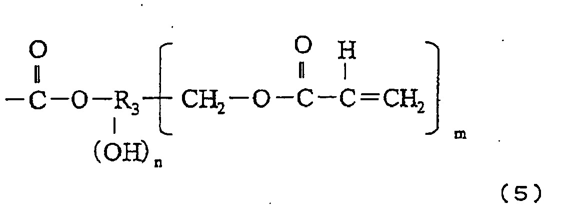 or 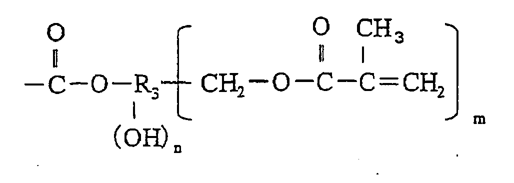 wherein R₃ represents a benzene ring or a cyclohexane ring, m represents 1 or 2, and n represents an integer from 0 to 2.

In the (meth)acrylic acid polymer having a carboxyl group and a (meth)acryloyl group, some of the acid groups may be substituted with an alkyl ester or a hydroalkyl ester.

The above (meth)acrylic acid polymer having a carboxyl group and a (meth)acryloyl group is one example which does not limit the present invention.

The (meth)acryloyl-modified novolac phenol resin of the present invention refers to a resin obtained by substituting some of the hydroxyl groups of a novolac phenol resin with the group shown by the following formula (3).

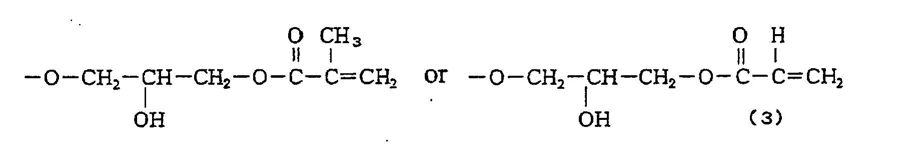

When two or more phenol compounds are polymerized via a methylene group, such a compound is referred to as "resin" such as a novolac phenol resin, and an unpolymerized monomer is referred to as "phenol compound". The novolac phenol resin used in the present invention includes a resin in which the phenol compound forming the molecular chain has one phenolic hydroxyl group (e.g., phenol and cresol), two phenolic hydroxyl groups (e.g., bisphenol A, bisphenol F, catechol, and resorcinol), or three or more phenolic hydroxyl groups (e.g., pyrogallol), or is a mixture of these phenol compounds. Among the novolac phenol resins, a polymer of phenol (C₆H₅OH) is referred to as "novolac phenol resin (phenol polymer)".

As examples of the phenol compound forming the molecular chain of the (meth)acryloyl-modified novolac phenol resin of the present invention, phenol, cresol, naphthol, hydroquinone, bisphenol A, bisphenol F, bisphenol E, bisphenol Z, bisphenol AF, bisphenol S, tetramethyl bisphenol F, tetramethyl bisphenol A, biphenol, diallyl bisphenol A, fluorenone bisphenol, and pyrogallol can be given. Among these, phenol, cresol, bisphenol F, and bisphenol A are preferable, with phenol and bisphenol A being particularly preferable in view of the balance between the heat resistance of the photosensitive adhesive resin composition after curing and the reliability of a semiconductor device.

The (meth)acryloyl-modified novolac phenol resin used as the compound (A) may be a resin obtained by the addition reaction of a hydroxyl group of a novolac phenol resin, which is obtained by reacting a phenol compound with formaldehyde, with an epoxy group of a (meth)acrylate having an epoxy group, for example.

From the viewpoint of the balance between developability and reactivity by exposure to light and thermal treatment, a (meth)acryloyl-modified bisphenol A shown by the following formula (1), 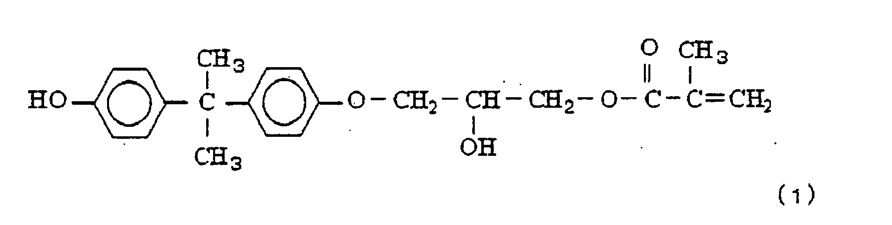 or 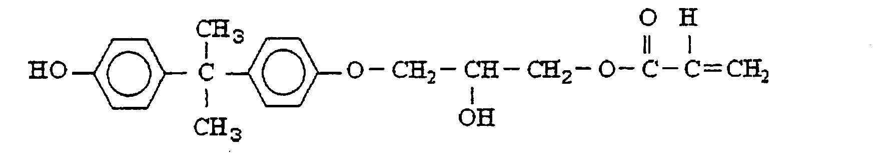 or a (meth)acryloyl-modified novolac bisphenol A resin obtained by substituting some of the hydroxyl groups of a novolac bisphenol A resin shown by the following formula (2) 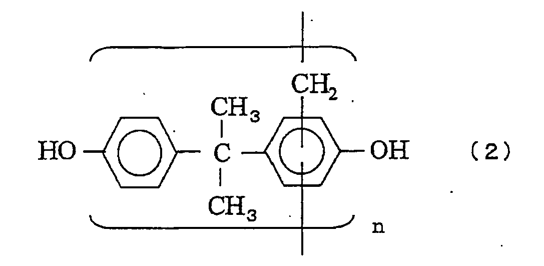 (wherein n is an integer from 2 to 15) with the group shown by the following formula (3) is particularly preferable as the compound (A).

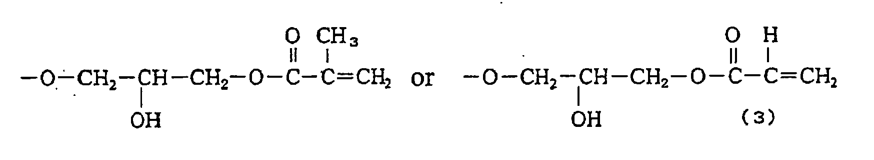

The above compounds may be used as the compound (A) either individually or in combination.

When the compound (A) is a (meth)acryloyl-modified novolac phenol resin, the number of phenols forming the structure of the resin is 2 to 15, and preferably 3 to 12. Developability of the photosensitive adhesive resin composition is better when the number of phenols forming the structure of the resin is in the above range.

The content of the compound (A) in the photosensitive adhesive resin composition is preferably 10 to 60 mass%, and particularly preferably 20 to 50 mass%. If the content of the compound (A) is within the above range, the photosensitive adhesive resin composition has high developability and excellent heat resistance after curing. The content of the compound (A) of the photosensitive adhesive resin composition in the form of varnish in which the components are dissolved or dispersed in a solvent indicates the percentage of the compound (A) with respect to the total amount of the compounds (A) to (E), and an optional filler (F) and other additives, excluding the solvent.

The compound (B) of the present invention is a resin which cures with the compound (A) by thermal treatment Examples of the compound (B) include, but are not limited to, bisphenol epoxy resins such as a bisphenol A epoxy resin and a bisphenol F epoxy resin, novolac epoxy resins such as a novolac epoxy resin and a cresol novolac epoxy resin, epoxy resins such as a biphenyl epoxy resins, a stilbene epoxy resin, a triphenolmethane epoxy resin, an alkyl-modified triphenolmethane epoxy resin, a triazine nucleus-containing epoxy resin, and a dicyclopentadiene-modified phenol epoxy resin, resins having a triazine ring such as a urea resin and a melamine resin, an unsaturated polyester resin, a bismaleimide resin, a polyurethane resin, a diallyl phthalate resin, a silicone resin, a resin having a benzoxazine ring, a cyanate ester resin, and the like. These resins may be used either individually or in combination of two or more. Among these, epoxy resins are preferable due to an excellent balance between the heat resistance and the adhesion of the photosensitive adhesive resin composition.

The weight average molecular weight of the compound (B) is preferably 200 to 10,000, and particularly preferably 300 to 5000. If the weight average molecular weight of the compound (B) is within the above range, the photosensitive adhesive resin composition has high reactivity in thermal curing and high adhesion after curing.

The content of the compound (B) in the photosensitive adhesive resin composition is preferably 10 to 40 mass%, and particularly 15 to 35 mass%. If the content of the compound (B) is within the above range, the photosensitive adhesive resin composition has excellent heat resistance and toughness after curing. The content of the compound (B) of the photosensitive adhesive resin composition in a form of varnish in which components are dissolved or dispersed in a solvent indicates the percentage of the compound (B) with respect to the total amount of the compounds (A) to (E), and an optional filler (F) and other additives, excluding the solvent.

Among the epoxy resins used as the compound (B), a combination of a bisphenol epoxy resin which is solid at 25°C and a silicone-modified epoxy resin which is liquid at 25°C is preferable due to excellent processability of the photosensitive adhesive resin composition such as tackiness and toughness after curing. In the present invention, the expression "solid at 25°C" indicates that the resin has a softening point of 25°C or higher, and the expression "liquid at 25°C" indicates that the resin has a softening point of less than 25°C.

When a compound which is liquid at 25°C is (partly) used as the compound (B), the content of the compound (B) which is liquid at 25°C in the photosensitive adhesive resin composition is preferably 20 mass% or less, and particularly preferably 15 mass% or less. If the content of the compound (B) which is liquid at 25°C is within the above range, a photosensitive adhesive resin composition exhibiting excellently balanced processability such as tackiness, toughness after curing, resolution in development, and adhesion can be obtained.

When all or a part of the compound (B) is liquid at 25°C and all or a part of the compound (C) is liquid at 25°C , the total content of the compound (B) which is liquid at 25°C and the compound (C) which is liquid at 25°C in the photosensitive adhesive resin composition is preferably 20 mass% or less, and particularly preferably 15 mass% or less. If the total content of the compound (B) which is liquid at 25°C and the compound (C) which is liquid at 25°C is within the above range, a photosensitive adhesive resin composition exhibiting excellently balanced processability such as tackiness, toughness after curing, resolution in development, and adhesion can be obtained.

The compound (C) used in the present invention is a compound having a (meth)acryloyl group and not having a hydroxyl group and a carboxyl group. The compound (C) used in the present invention is not particularly limited so long as the compound has a (meth)acryloyl group. Examples of the compound (C) include a monofunctional (meth)acrylate having one (meth)acryloyl group, a bifunctional (meth)acrylate having two (meth)acryloyl groups, and a polyfunctional (meth)acrylate having three or more (meth)acryloyl groups. Specific examples of the compound (C) include bifunctional (meth)acrylates such as ethylene glycol di(meth)acrylate, 1,6-hexanediol di(meth)acrylate, glycerine di(meth)acrylate, and 1,10-decanediol di(meth)acrylate; and polyfunctional (meth)acrylates such as trimethylolpropane tri(meth)acrylate, pentaerythritol tri(meth)acrylate, and dipentaerythritol hexa(meth)acrylate. The compound (C) also includes polyalkylene glycol di(meth)acrylates such as polyethylene glycol di(meth)acrylate and polypropylene glycol di(meth)acrylate. Urethane (meth)acrylate, epoxy (mem)acrylate, and the like can also be given as the compound (C).

Urethane (meth)acrylate is a compound obtained by producing a urethane compound by forming a urethane bond by the reaction of a hydroxyl group of a polyol and an isocyanate group of a compound having two or more isocyanate groups, then reacting the isocyanate groups in the resulting urethane compound which have not been used for the reaction with the polyol and the hydroxyl group of a compound having a hydroxyl group and a (meth)acryloyl group to form a urethane bond.

Epoxy acrylate is a compound obtained by reacting an epoxy group in the epoxy resin and a carboxyl group in the compound having a carboxyl group and a (meth)acryloyl group to form an ester bond.

Examples of the urethane (meth)acrylate include a compound obtained by adding 2-hydroxyethyl (meth)acrylate to a urethane compound which is obtained by the reaction of a polyalkylene glycol and a diisocyanate. Examples of the epoxy (meth)acrylate also include a compound obtained by reacting an epoxy group on each end of an epoxy resin such as a bisphenol A epoxy resin or a bisphenol F epoxy resin with a carboxyl group of (meth)acrylic acid to form an ester bond.

Among these, bifunctional (meth)acrylates such as triethylene glycol di(meth)acrylate, 1,6-hexanediol di(meth)acrylate, glycerin di(meth)acrylate, and 1,10-decanediol di(meth)acrylate, particularly triethylene glycol di(meth)acrylate, are preferable as the compound (C) from the viewpoint of well-balanced phtocurability and toughness of the photosensitive adhesive resin composition.

The weight average molecular weight of the compound (C) is 3000 or less, preferably 100 to 2500, and particularly preferably 200 to 2000. If the weight average molecular weight of the compound (C) is within the above range, developability of the photosensitive adhesive resin composition is better.

It is preferable that the compound (C) be liquid at 25°C. This makes higher phtocurability of the photosensitive adhesive resin composition. Moreover, the compound (C) can be easily mixed with the compound (B).

The content of the compound (C) in the photosensitive adhesive resin composition is preferably 3 to 30 mass%, and particularly 5 to 20 mass%. If the content of the compound (C) is within the above range, the photocurability, heat resistance, and toughness of the photosensitive adhesive resin composition can be better. The content of the compound (C) of the photosensitive adhesive resin composition in a form of varnish in which components are dissolved or dispersed in a solvent indicates the percentage of the compound (C) in the total amount of the compounds (A) to (E), and optionally-added filler (F) and other additives, excluding the solvent

When all or a part of the compound (C) is liquid at 25°C, the content of the compound (C) which is liquid at 25°C in the photosensitive adhesive resin composition is preferably 20 mass% or less, and particularly preferably 15 mass% or less. If the content of the compound (C) is within the above range, a photosensitive adhesive resin composition exhibiting excellently balanced processability such as tackiness, photocurability, resolution in development, and adhesion can be obtained.

The compound (D) used in the present invention is a phenol resin or a phenol compound not having a (meth)acryloyl group. This compound improves developability when the photosensitive adhesive resin composition is developed using an alkaline developer. Although the compound (A) contained in the photosensitive adhesive resin composition is soluble in an alkaline developer, the concentration of phenolic hydroxyl groups in the photosensitive adhesive resin composition and the solubility in an alkaline developer are increased by adding the compound (D). After acting as a development improver during alkali development, the compound (D) has a function of reacting with the compound (B) when the photosensitive adhesive resin composition is cured thermally. The compound (D) is thus incorporated into the matrix of the cured material, thereby preventing pollution of the transparent substrate and the substrate on which a semiconductor element is formed and suppressing a decrease in the heat resistance and moisture resistance.

The phenol resin used as the compound (D) in the present invention is a resin having a phenolic hydroxyl group in the molecular chain. The phenol resin used as the compound (D) includes a novolac phenol resin. Examples of the compound (D) include, but are not limited to, novolac phenol resins such as a novolac phenol resin (phenol polymer), a novolac orthocresol resin, and a novolac bisphenol A resin, dicyclopentadiene phenol resins in which dicyclopentadiene and a phenol compound are bonded as shown by the following formula (6), 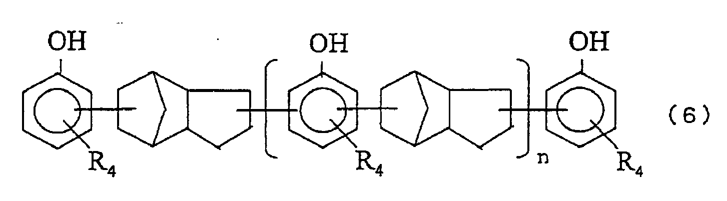 wherein n is an integer from 0 to 10 and R₄ represents a hydrogen atom or a methyl group, and dicyclopentadiene phenol resins in which an aralkyl group and a phenol compound are bonded as shown by the following formula (7), 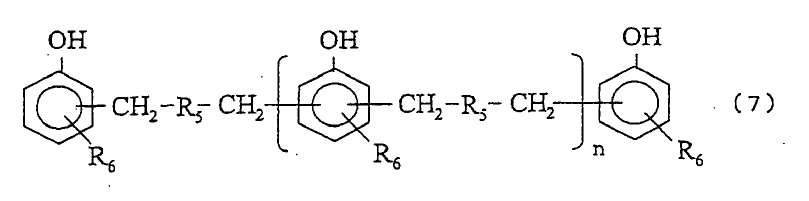 wherein n is an integer from 0 to 10, R₅ individually represents a group selected from benzene, naphthalene, and biphenyl, and R₆ represents a hydrogen atom or a methyl group.

Of these, novolac phenol resins are preferable due to excellent developability and capability of increasing heat resistance and toughness of cured materials of the photosensitive adhesive resin composition. As the phenol compounds forming the molecular chain of the novolac phenol resins of the compound (D), those previously given as examples of the phenol compounds forming the molecular chain of the (meth)acryloyl-modified novolac phenol resins of the compound (A) can be given.

Examples of the phenol compound used as the compound (D) include, but are not limited to, phenols such as bisphenol A, bisphenol F, bisphenol AD, biphenol, tetramethylbiphenol, bis(4-hydroxyphenyl)methane, bis(4-hydroxyphenyl)propane, terpendiphenol, hydroquinone, methyl hydroquinone, dibutyl hydroquinone, resorcin, methyl resorcin, bisphenol S, thiodiphenol, dihydroxy diphenyl ether, and dihydroxy naphthalene. Of these, bisphenol A, bisphenol F, biphenol, and bisphenol S, particularly bisphenol A and bisphenol F are preferable due to excellent developability and capability of increasing heat resistance and toughness of cured materials of the photosensitive adhesive resin composition.

The content of the compound (D) in the photosensitive adhesive resin composition is preferably 0.1 to 20 mass%, and particularly preferably 2 to 15 mass%. If the content of the compound (D) is within the above range, all of the properties such as developability, heat resistance, and toughness of the photosensitive adhesive resin composition after curing can be better. The content of the compound (D) of the photosensitive adhesive resin composition in a form of varnish in which components are dissolved or dispersed in a solvent indicates the percentage of the compound (D) in the total amount of the compounds (A) to (E), and optionally-added filler (F) and other additives, excluding the solvent.

The weight average molecular weight of the compound (D) is 100 to 5000, and preferably 200 to 3000. If the compound (D) has a weight average molecular weight within these ranges, the compound (D) has good solubility in a developer and, therefore, the photosensitive adhesive resin composition has good developability.

There are no specific limitations to the photoactive compound (E) used in the present invention. Benzophenone, acetophenone, benzoin, benzoin isobutyl ether, methyl benzoin benzoate, benzoin benzoate, benzoin methyl ether, benzyl phenyl sulfide, benzyl, dibenzyl, diacetyl, and the like can be given as examples.

The content of the photoactive compound (E) in the photosensitive adhesive resin composition is preferably 0.5 to 5 mass%, and particularly preferably 0.8 to 2.5 mass%. If the content of the photoactive compound (E) is within the above range, the photosensitive adhesive resin composition can maintain well-balanced photocurability, storage stability, and resolution. The content of the photoactive compound (E) of the photosensitive adhesive resin composition in a form of varnish in which components are dissolved or dispersed in a solvent indicates the percentage of the compound (E) in the total amount of the compounds (A) to (E), and optionally-added filler (F) and other additives, excluding the solvent.

The filler (F) may be added to the photosensitive adhesive resin composition in order to increase heat resistance, moisture resistance, and mechanical strength after curing.

Examples of the filler (F) added to the photosensitive adhesive resin composition of the present invention include, but are not limited to, fibrous fillers such as alumina fiber and glass fiber, acicular fillers such as potassium titanate, wollastonite, aluminum borate, acicular magnesium hydroxide, and whisker, plate-like fillers such as talc, mica, sericite, glass flakes, flaky graphite, and plate-like calcium carbonate, and spherical (particulate) fillers such as calcium carbonate, silica, molten silica, sintered clay, and non-sintered clay. Of these, spherical (particulate) fillers are preferable due to capability of ensuring well-balanced developability and flowability in thermal compression bonding. Silica is particularly preferable due to low contamination and high mechanical strength of the cured material.

The content of the filler (F) in the photosensitive adhesive resin composition is preferably 3 to 50 mass%, and particularly preferably 10 to 40 mass%. If the content of the filler (F) is within the above range, a photosensitive adhesive resin composition exhibiting excellently balanced heat resistance and moisture resistance after curing, and exhibiting excellently balanced strength and light transmittance during exposure when the photosensitive adhesive resin composition is applied between a transparent substrate and a substrate on which a semiconductor element is formed can be obtained.

The average particle diameter of the filler (F) is preferably 0.03 to 0.40 µm, and particularly preferably 0.10 to 0.30 µm. If the average particle diameter of the filler (F) is within the above range, a photosensitive adhesive resin composition exhibiting excellently balanced mechanical strength and light transmittance in exposure to light can be obtained.

The average particle diameter of the filler (F) is measured by ultrasonically dispersing the filler in water for one minute and using a laser diffraction particle size distribution meter "SALD-7000". The resulting D50 value (integrated number) is regarded as the average particle diameter.

The maximum particle diameter of the filler (F) is preferably 0.10 to 1.0 µm, and particularly preferably 0.15 to 0.90 µm. If the maximum particle diameter of the filler (F) is within the above range, a photosensitive adhesive resin composition exhibiting excellently balanced mechanical strength and light transmittance during exposure to radiation can be obtained.

The maximum particle diameter of the filler (F) is measured by ultrasonically dispersing the filler (F) in water for one minute and using a laser diffraction particle size distribution meter "SALD-7000". The resulting D100 value (integrated number) is regarded as the maximum particle diameter.

The filler (F) may be either treated or not treated by a coupling treatment. The filler has an effect of increasing strength of the photosensitive adhesive resin composition by an increase in the adhesion of the resin component with the filler interfaces.

To the extent not adversely affecting the effect of the present invention, the photosensitive adhesive resin composition may contain additives such as a plastic resin, a leveling agent, a defoamer, a coupling agent, and an organic peroxide.

The photosensitive adhesive resin composition of the present invention may have either a form of varnish or may be formed into a film. It is possible to prepare a varnish by dissolving or dispersing components forming the photosensitive adhesive resin composition such as the compound (A), the compound (B), the compound (C), the compound (D), and the sensitizer (E) in an organic solvent such as N-methyl-2-pyrrolidone, anisole, methyl ethyl ketone, toluene, and ethyl acetate. A film of the photosensitive adhesive resin composition can be obtained by forming the varnish into a layer, and drying for removing the solvent

The adhesive film of the present invention comprises a base film and an adhesive layer formed on the surface of the base film, wherein the adhesive layer is made from the photosensitive adhesive resin composition of the present invention.

The base film is a film support having properties such as excellent breaking strength and flexibility required for maintaining the adhesive layer in the form of a film. When the adhesive film is used for patterning by exposing to light through a mask pattern placed on the base film, it is preferable that the base film be transparent. As the base film, polyethylene terephthalate (PET), polypropylene (PP), polyethylene (PE), and the like can be given. Of these, polyethylene terephthalate (PET) is preferable from the viewpoint of well-balanced transparency and breaking strength.

A protective film may be provided on the adhesion film of the present invention in order to protect the surface of the adhesion layer. Any film having properties of maintaining the film conditions of the adhesive layer such as breaking strength and flexibility, particularly peelability from the adhesive layer, can be used as the protective film without particular limitations. As examples, a polyethylene terephthalate (PET), polypropylene (PP), and polyethylene (PE) can be given. The protective film may be made from a non-transparent material.

One embodiment of a method for using the adhesive film and a light-receiving device of the present invention will be explained with reference to Figs. 1 and 2. Fig. 1 is a schematic cross-sectional view showing one embodiment of the method for using the adhesive film of the present invention, and Fig. 2 is a schematic cross-sectional view showing the light-receiving device.

As shown in Figs. 1(A) and 1(B), a semiconductor wafer 9, in which semiconductor elements 11 are regularly arranged on a plane via support substrate 10, is formed on a base substrate 12. An adhesive film 14 is attached to the base substrate 12 so that the adhesive film 14 covers the base substrate 12. The thickness of an adhesive layer 15 of the adhesive film 14 is 5 to 100 µm.

A base film 16 is removed, and the base substrate 12 to which the adhesive layer 15 is attached is aligned with an exposure machine (not shown).

In this instance, a alignment mark (not shown) is formed on the surface of the base substrate 12 to which the adhesive layer 15 is attached. A mask of the exposure machine is aligned with the base substrate 12 using the alignment mark. Alignment is performed in the visible region (wavelength: 400 to 750 nm).

After aligning the exposure machine with the base substrate 12, light (UV light) is selectively applied to the adhesive layer 15 from the exposure machine to cure the exposed areas of the adhesive layer 15. After exposure, the adhesive layer 15 is developed in a developer (for example, an alkaline aqueous solution or an organic solvent) so that the irradiated areas remain without being dissolved in the developer. The adhesive layer 15 remain on the base substrate 12 in the areas other than the light receiving section 17 around the light receiving section 17 (see Fig. 1(C)).

A transparent substrate 13 is then placed on the adhesive layer 15, and the base substrate 12 is bonded to the transparent substrate 13 via the adhesive layer 15 (see Fig. 1(D)). For example, the base substrate 12 and the transparent substrate 13 are press-heated to cure the heat-curable component of the adhesive layer 15 so that the base substrate 12 and the transparent substrate 13 are bonded via the adhesive layer 15. The press-heating temperature is 80°C to 180°C.

In this instance, the transparent substrate 13 is aligned according to the alignment mark formed on the base substrate 12.

The base substrate 12 and the transparent substrate 13 are then diced in units of the light receiving section (see Fig. 1(E)). Specifically, notches trenchs 18 are formed in the base substrate 12 using a dicing machine to dice the base substrate 12 and the transparent substrate 13 in units of the light receiving section.

A light-receiving device 1 shown in Fig. 2 can be obtained in this process.

The photosensitive adhesive resin composition of the present invention thus has a function of a spacer formed between the substrate on which the semiconductor element is formed and the transparent substrate facing the substrate.

The effects of the photosensitive adhesive resin composition of the present invention are described below. The photosensitive adhesive resin composition comprises the compound (D). The compound (D) improves the solubility of the photosensitive adhesive resin composition in an alkaline developer after exposure, whereby the developability of the composition is improved.

The amount of phenolic hydroxyl groups in the photosensitive adhesive resin composition can be increased by utilizing a (meth)acryloyl-modified novolac phenol resin as the compound (A), so that solubility and developability in an alkaline developer are better.

Addition of the filler in an amount of 3 to 50 mass% further makes the higher heat resistance and the higher moisture resistance of the photosensitive adhesive resin composition (i.e., a photosensitive adhesive resin composition which exhibits excellent transparency and alignment properties can be obtained).

The photosensitive adhesive resin composition exhibits high transparency and remains to has no residue in development process by utilizing a filler having an average particle diameter of 0.03 to 0.4 µm. This facilitates alignment of the base substrate 12 with the mask of the exposure machine and alignment of the base substrate 12 with the transparent substrate 13 after curing the photosensitive adhesive resin composition. Moreover, a clear image can be gotten due to no residue on the transparent substrate and the semiconductor element.

The present invention is not limited to the above embodiments. Modifications and improvements may be made without departing from the scope of the present invention.

In the above embodiments, the base substrate 12 is bonded to the transparent substrate 13 after laminating the adhesive film 14 prepared from the photosensitive adhesive resin composition in the form of a film on the base substrate 12. Note that the adhesive film may be laminated on the transparent substrate. In this case, the alignment mark formed on the transparent substrate is aligned with the mask.

In the above embodiments, the transparent substrate 13 is bonded using the adhesive layer 15 after laminating the adhesive film 14 on the base substrate 12, followed by dicing. Note that it is possible to laminate the adhesive film 14 on the base substrate 12, dice the base substrate 12 in units of semiconductor elements, and then bond the transparent substrate 13 to the base substrate 12.

In the above embodiments, the adhesive film prepared by forming the photosensitive adhesive resin composition on the base film is laminated on the base substrate 12. Note that it is possible to prepare a varnish of the photosensitive adhesive resin composition, and apply the varnish to the base substrate 12.

### EXAMPLES

The present invention is described below in more detail by way of examples and comparative examples, which are not intended to limit the present invention.

### <Example 1>

### 1. Compound (A): Synthesis of metacryloyl-modified novolac bisphenol A resin MPN001

A 21 1 flask was charged with 500 g of a solution of a novolac bisphenol A resin (Phenolite LF-4871 manufactured by Dainippon Ink and Chemicals, Inc.) in MEK (methyl ethyl ketone) with a solid content of 60%. After the addition of 1.5 g of tributylamine (catalyst) and 0.15 g of hydroquinone (polymerization inhibitor), the mixture was heated to 100°C. 180.9 g of glycidyl methacrylate was added dropwise to the mixture over 3 0 minutes, and the mixture was stirred at 100°C for five hours to obtain a methacryloyl-modified novolac bisphenol A resin MPN 001 (methacryloyl-modification rate: 50%) with a solid content of 74%.

### 2. Preparation of varnish of photosensitive adhesive resin composition

44.5 mass% of the methacryloyl-modified novolac bisphenol A resin MPN 001 as the compound (A), 30.0 mass% of bisphenol A novolac epoxy resin (N865 manufactured by Dainippon Ink and Chemicals, Inc.) and 5.3 mass% of silicone-modified epoxy resin (BY16-115 manufactured by Toray-Dow Corning Silicone Co., Ltd.) as the compound (B), 14.7 mass% of triethylene glycol dimethacrylate (NK Ester 3G manufactured by Shin-Nakamura Chemical Co., Ltd.) as the compound (C), 3.5 mass% of a phenol novolac resin (PR53647 manufactured by Sumitomo Bakelite Co., Ltd.) as the compound (D), and 2.0 mass% of 2,2-dimethoxy-1,2-diphenylethan-1-on (Irgacure 651 manufactured by Chiba Specialty Chemicals, Inc.) as the photoactive compound (E) were dissolved in MEK (methyl ethyl ketone manufactured by Daishin-Chemical Co., Ltd.) to obtain a varnish of a photosensitive adhesive resin composition with a solid content of 71%. The amount of the metacryloyl-modified novolac bisphenol A resin MPN001 in the varnish of the photosensitive adhesive resin composition is the solid content

### 3. Preparation of adhesive film

The varnish of the photosensitive adhesive resin composition was applied to a transparent PET film (thickness: 25 µm), and dried at 80°C for 15 minutes to form an adhesive layer with a thickness of 50 µm. An adhesive film is thus obtained.

### 4. Preparation of light-receiving device

The above adhesive film was laminated on a semiconductor wafer, and a resin spacer (void) was formed by exposure and development A glass substrate was thermally bonded to the top end of the resin spacer at 120°C. The semiconductor wafer was then diced to obtain light-receiving devices.

### <Example 2>

Light-receiving devices were obtained in the same process as in Example 1, except for using 3.5 mass% of bisphenol A (BPA manufactured by Honshu Chemical Co., Ltd.) instead of 3.5 mass% of the phenol novolac resin (PR53647 manufactured by Sumitomo Bakelite Co., Ltd.) as the compound (D).

### <Example 3>

An adhesive film and light-receiving devices were obtained in the same process as in Example 1, except for using 44.5 mass% of an acrylic acid polymer having a carboxyl group and a (meth)acryloyl group (Cyclomer PACA200M manufactured by Daicel Chemical Industries) instead of 44.5 mass% of the methacryloyl-modified novolac bisphenol A resin MPN 001 as the compound (A). The amount of the acrylic acid polymer having a carboxyl group and a (meth)acryloyl group (Cyclomer P ACA200M manufactured by Daicel Chemical Industries) is the solid content

### <Example 4>

An adhesive film and light-receiving devices were obtained in the same process as in Example 1, except for decreasing the amount of the methacryloyl-modified novolac bisphenol A resin MPN 001 used as the compound (A) from 44.5 mass% to 40.5 mass% and increasing the amount of the phenol novolac resin (PR53647 manufactured by Sumitomo Bakelite Co., Ltd.) used as the compound (D) from 3.5 mass% to 7.5 mass%.

### <Example 5>

An adhesive film and light-receiving devices were obtained in the same process as in Example 1, except for decreasing the amount of the methacryloyl-modified novolac bisphenol A resin MPN 001 used as the compound (A) from 44.5 mass% to 33.0 mass% and increasing the amount of the phenol novolac resin (PR53647 manufactured by Sumitomo Bakelite Co., Ltd.) used as the compound (D) from 3.5 mass% to 15.0 mass%.

### <Example 6>

An adhesive film and light-receiving devices were obtained in the same process as in Example 1, except for changing the composition of photosensitive adhesive resin composition varnish as follows.

29.5 mass% of the methacryloyl-modified novolac bisphenol A resin MPN 001 as the compound (A), 19.9 mass% of bisphenol A novolac epoxy resin (N865 manufactured by Dainippon Ink and Chemicals, Inc.) and 3.6 mass% of silicone-modified epoxy resin (BY16-115 manufactured by Toray-Dow Corning Silicone Co., Ltd.) as the compound (B), 9.8 mass% of triethylene glycol dimethacrylate (NK Ester 3G manufactured by Shin-Nakamura Chemical Co., Ltd.). as the compound (C), and 2.3 mass% of a phenol novolac resin (PR53647 manufactured by Sumitomo Bakelite Co., Ltd.) as the compound (D) were dissolved in MEK (methyl ethyl ketone manufactured by Daishin-Chemical Co., Ltd.) to obtain a varnish with a solid content of 71%.

As the filler (F), 33.7 mass% of silica (SO-E2 manufactured by Admatechs Co., Ltd. average particle diameter: 0.5 µm, maximum particle diameter: 2.0 µm) was dispersed in the varnish using a bead mill (bead diameter: 400 µm, processing speed: 6 g/s, five pass).

As the photoactive compound (E), 1.2 mass% of 2,2-dimethoxy-1,2-diphenylethan-1-on (Irgacure 651 manufactured by Ciba Specialty Chemicals Co., Ltd.) was added and the mixture was stirred at 450 rpm for one hour to obtain a photosensitive adhesive resin composition varnish.

### <Example 7>

An adhesive film and light-receiving devices were obtained in the same process as in Example 1, except for changing the composition of the photosensitive adhesive resin composition varnish as follows.

29.5 mass% of the methacryloyl-modified novolac bisphenol A resin MPN 001 as the compound (A),19.9 mass% of bisphenol A novolac epoxy resin (N865 manufactured by Dainippon Ink and Chemicals, Inc.) and 3.6 mass% of silicone-modified epoxy resin (BY16-115 manufactured by Toray-Dow Corning Silicone Co., Ltd.) as the compound (B), 9.8 mass% of triethylene glycol dimethacrylate (NK Ester 3G manufactured by Shin-Nakamura Chemical Co., Ltd.). as the compound (C), and 2.3 mass% of a phenol novolac resin (P53647 manufactured by Sumitomo Bakelite Co., Ltd.) as the compound (D) were dissolved in MEK (methyl ethyl ketone manufactured by Daishin-Chemical Co., Ltd.) to obtain a varnish with a solid content of 71%.

As the filler (F), 33.7 mass% of silica (KE-P30 NIPPON SHOKUBAI Co., Ltd., average particle diameter: 0.28 µm, maximum particle diameter: 0.9 µm) was dispersed in the varnish using a bead mill (bead diameter: 400 µm, processing speed: 6 g/s, five pass).

As the sensitizer (E), 1.2 mass% of 2,2-dimethoxy-1,2-diphenylethan-1-on (Irgacure 651 manufactured by Ciba Specialty Chemicals Co., Ltd.) was added and the mixture was stirred at 450 rpm for one hour to obtain a photosensitive adhesive resin composition varnish.

### <Example 8>

An adhesive film and light-receiving devices were obtained in the same process as in Example 6, except for using 33.7 mass% of silica (NSS-3N manufactured by Tokuyama Co., Ltd., average particle diameter: 0.125 µm, maximum particle diameter: 0.35 µm) instead of 33.7 mass% of silica (SO-E2 manufactured by Admatechs Co., Ltd. average particle diameter: 0.5 µm, maximum particle diameter: 2.0 µm) as the filler (F).

### <Example 9>

An adhesive film and light-receiving devices were obtained in the same process as in Example 6, except for using 33.7 mass% of silica (SFP-20M manufactured by DENKA Co., Ltd., average particle diameter: 0.33 µm, maximum particle diameter: 0.8 µm) instead of 33.7 mass% of silica (SO-E2 manufactured by Admatechs Co., Ltd., average particle diameter: 0.5 µm, maximum particle diameter: 2.0 µm) as the filler (F).

### <Example 10>

An adhesive film and light-receiving devices were obtained in the same process as in Example 6, except for using 33.7 mass% of silica (KE-S30 manufactured by NIPPON SHOKUBAI Co., Ltd., average particle diameter: 0.24 µm, maximum particle diameter: 0.9 µm) instead of 33.7 mass% of silica (SO-E2 manufactured by Admatechs Co., Ltd. average particle diameter: 0.5 µm, maximum particle diameter: 2.0 µm) as the filler (F).

### <Example 11>

An adhesive film and light-receiving devices were obtained in the same process as in Example 6, except for changing the composition of the photosensitive adhesive resin composition varnish as follows.

42.0 mass% of the methacryloyl-modified novolac bisphenol A resin MPN 001 as the compound (A), 28.5 mass% of bisphenol A novolac epoxy resin (N865 manufactured by Dainippon Ink and Chemicals, Inc.) and 5.1 mass% of silicone-modified epoxy resin (BY16-115 manufactured by Toray-Dow Corning Silicone Co., Ltd.) as the compound (B), 13.9 mass% of triethylene glycol dimethacrylate (NK Ester 3G manufactured by Shin-Nakamura Chemical Co., Ltd.). as the compound (C), and 3.3 mass% of a phenol novolac resin (PR53647 manufactured by Sumitomo Bakelite Co., Ltd.) as the compound (D) were dissolved in MEK (methyl ethyl ketone manufactured by Daishin-Chemical Co., Ltd.) to obtain a varnish with a solid content of 71%.

As the filler (F), 5.0 mass% of silica (SO-E2 manufactured by Admatechs Co., Ltd. average particle diameter: 0.5 µm, maximum particle diameter: 2.0 µm) was dispersed in the varnish using a bead mill (bead diameter: 400 µm, processing speed: 6 g/s, five pass).

As the photoactive compound (E), 2.2 mass% of 2,2-dimethoxy-1,2-diphenylethan-1-on (Irgacure 651 manufactured by Ciba Specialty Chemicals Co., Ltd.) was added and the mixture was stirred at 450 rpm for one hour to obtain a photosensitive adhesive resin composition varnish.

### <Example 12>

An adhesive film and light-receiving devices were obtained in the same process as in Example 6, except for changing the composition of the photosensitive adhesive resin composition varnish as follows. mass% of the methacryloyl-modified novolac bisphenol A resin MPN 001 as the compound (A), 24.3 mass% of bisphenol A novolac epoxy resin (N865 manufactured by Dainippon Ink and Chemicals, Inc.) and 4.3 mass% of silicone-modified epoxy resin (BY16-115 manufactured by Toray-Dow Corning Silicone Co., Ltd.) as the compound (B), 11.8 mass% of triethylene glycol dimethacrylate (NK Ester 3G manufactured by Shin-Nakamura Chemical Co., Ltd.). as the compound (C), and 2.8 mass% of a phenol novolac resin (PR53647 manufactured by Sumitomo Bakelite Co., Ltd.) as the compound (D) were dissolved in MEK (methyl ethyl ketone manufactured by Daishin-Chemical Co., Ltd.) to obtain a varnish with a solid content of 71 %.

As the filler (F), 20.0 mass% of silica (SO-E2 manufactured by Admatechs Co., Ltd. average particle diameter: 0.5 µm, maximum particle diameter: 2.0 µm) was dispersed in the varnish using a bead mill (bead diameter: 400 µm, processing speed: 6 g/s, five pass).

As the sensitizer (E), 1.8 mass% of 2,2-dimethoxy-1,2-diphenylethan-1-on (Irgacure 651 manufactured by Ciba Specialty Chemicals Co., Ltd.) was added and the mixture was stirred at 450 rpm for one hour to obtain a photosensitive adhesive resin composition varnish.

### <Comparative Example 1>

An adhesive film and light-receiving devices were obtained in the same process as in Example 1, except for changing the composition of the photosensitive adhesive resin composition varnish as follows.

46.5 mass% of the methacryloyl-modified novolac bisphenol A resin MPN 001 as the compound (A), 31.0 mass% of bisphenol A novolac epoxy resin (N865 manufactured by Dainippon Ink and Chemicals, Inc.) and 5.3 mass% of a silicone-modified epoxy resin (BY16-115 manufactured by Toray-Dow Corning Silicone Co., Ltd.) as the compound (B), 14.8 mass% of triethylene glycol dimethacrylate (NK Ester 3G manufactured by Shin-Nakamura Chemical Co., Ltd.). as the compound (C), and 2.4 mass% of 2,2-dimethoxy-1,2-diphenylethan-1-on (Irgacure 651 manufactured by Ciba Specialty Chemicals, Inc.) as the photoactive compound (E) were dissolved in MEK (methyl ethyl ketone manufactured by Daishin-Chemical Co., Ltd.) to obtain a photosensitive adhesive resin composition with a solid content of 71%.

The following properties of the adhesive films obtained in the Examples and Comparative Examples were evaluated. The evaluated properties and the methods of evaluation are given below. The results are shown in Table 1.

### 1. Developability

An adhesive film was laminated onto a semiconductor wafer (temperature: 60°C, rate: 0.3 m/min), exposed to light through a mask pattern to leave resin spacers in a lattice-shaped pattern (exposure dose: 700 mJ/cm²), and developed in 3%TMAH (developing pressure: 0.2 MPa, developing time: 150 sec). The resulting lattice-shaped pattern was observed using an electron microscope (magnification: 5000) to inspect for the presence or absence of residues. The results were classified as follows.
AAA: No problem in practice at all with no residue whatsoever being observed.
BBB: No problem in practice although some residues were observed.
CCC: Unusable in practice with comparatively a large number of residues being observed.
DDD: Unusable in practice with many residues being observed.

A mask with a lattice-shaped pattern of a resin width of 1.2 mm and an interval of 5 mm was used.

### 2 Reliability of light-receiving device

The light-receiving devices obtained in the Examples and Comparative Examples were subjected to a temperature cycle test of leaving at -55°C for one hour and 125°C for one hour. After 100 cycles (n = 10), samples were observed for presence or absence of cracks and peeling. The results were classified as follows. AAA: No problem in practice at all with no cracks and peeling observed in any samples.
BBB: No problem in practice even though cracks and peeling were observed in two or less samples.
CCC: Unusable in practice with cracks and peeling being observed in three or more samples.
DDD: Unusable in practice with cracks and peeling being observed in eight or more samples.

### 3. Alignment properties

An adhesive film was laminated on a semiconductor wafer (temperature: 60°C, rate: 0.3 m/min) to evaluate visibility of the pattern on the surface of the semiconductor wafer through the laminated film for resin spacer using an exposure machine PLA-600FA (manufactured by Canon Inc.). The results were classified as follows. AAA: No problem in practice at all with boundaries of the pattern shape being vividly observed.
BBB: No problem in practice with boundaries being observed somewhat indistinct although the pattern shape can be identified.
DDD: Unusable in practice with no patterns being observed.

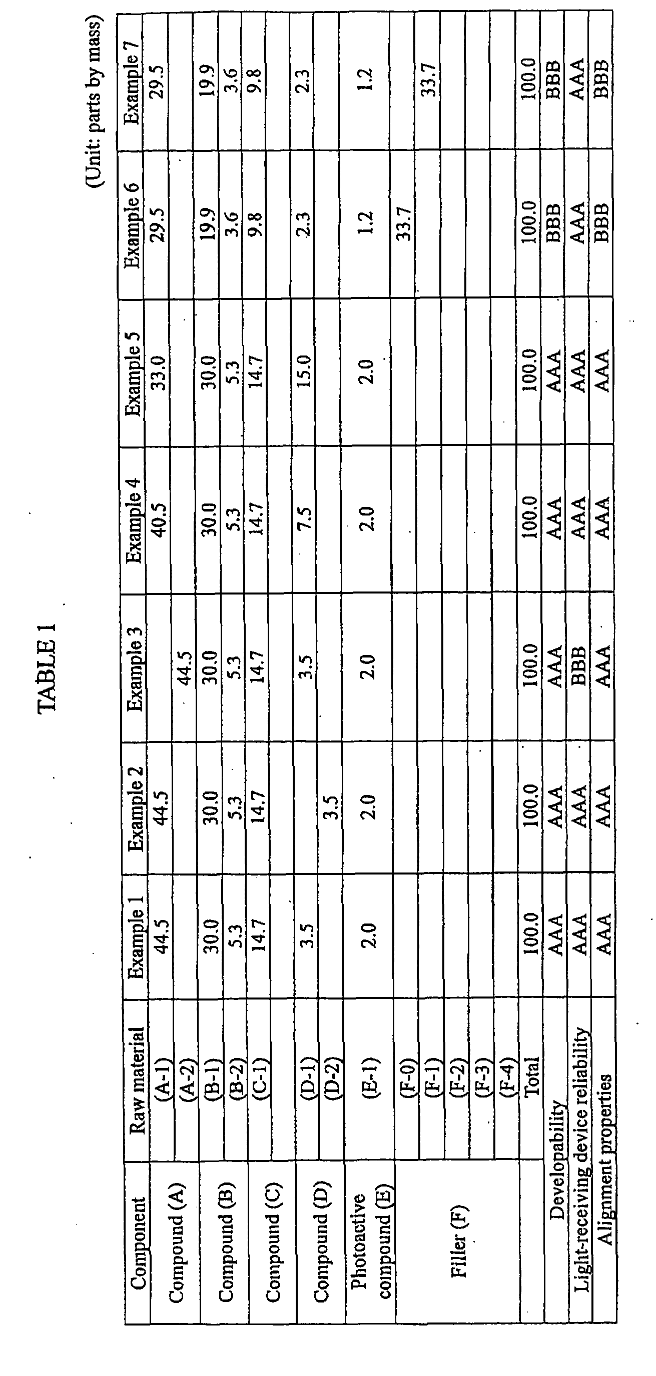

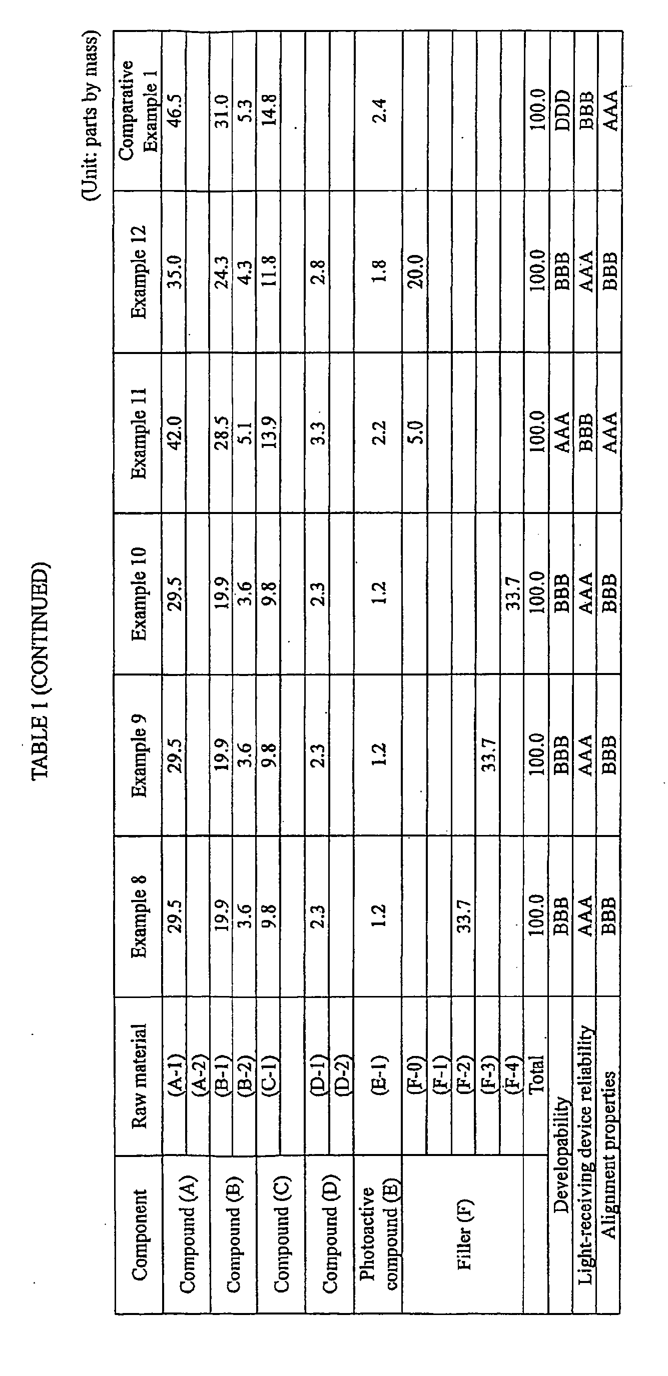

### <Compound (A)>

(A-1) Methaeryloyl-modified novolac bisphenol A resin MPN 001
(A-2) Acrylic polymer having carboxyl group and (meth)acryloyl group (Cyclomer P ACA200M manufactured by Daicel Chemical Industries)

### <Compound (B)>

(B-1) Bisphenol A novolac epoxy resin (N865 manufactured by Dainippon Ink and Chemicals, Inc.)
(B-2) Silicone-modified epoxy resin (BY16-115 manufactured by Toray-Dow Corning Silicone Co., Ltd.)

### <Compound (C)>

(C-1) Triethylene glycol dimethacrylate (NK Ester 3G manufactured by Shin-Nakamura Chemical Co., Ltd.)

### <Compound (D)>

(D-1) Phenol novolac resin (PR53647 manufactured by Sumitomo Bakelite Co., Ltd.)
(D-2) Bisphenol A (BPA manufactured by Honshu Chemical Co., Ltd.)

### <Photoactive compound (E)>

(E-1) Sensitizer (Irgacure 651 manufactured by Ciba Specialty Chemicals, Inc.)

### <Photoactive filler (F)>

(F-0) Silica (SO-E2 manufactured by Admatechs Co., Ltd. average particle diameter: 0.5 µm, maximum particle diameter: 2.0 µm)
(F-1) Silica (KE-P30 NIPPON SHOKUBAI Co., Ltd., average particle diameter: 0.28 µm, maximum particle diameter: 0.9 µm)
(F-2) Silica (NSS-3N manufactured by Tokuyama Co., Ltd., average particle diameter: 0.125 µm, maximum particle diameter: 0.35 µm)
(F-3) Silica (SFP-20M manufactured by Denka Co., Ltd., average particle diameter: 0.33 µm, maximum particle diameter: 0.8 µm)
(F-4) Silica (KE-S30 manufactured by NIPPON SHOKUBAI Co., Ltd., average particle diameter: 0.24 µm, maximum particle diameter: 0.9 µm)

- 1: Light-receiving device
- 9: Semiconductor wafer
- 10: Support substrate
- 11: Semiconductor element
- 12: Base substrate
- 13: Transparent substrate
- 14: Adhesive film
- 15: Adhesive layer
- 16: Base film
- 17: light receiving section
- 18: Trench

## Claims

1. A photosensitive adhesive resin composition comprising (A) a compound having a hydroxyl group or a carboxyl group, and a (meth)acryloyl group, (B) a resin which cures with the compound (A) by thermal treatment, (C) a compound having a (meth)acryloyl group and not having a hydroxyl group and a carboxyl group, (D) a phenol resin or a phenol compound, and (E) a photoactive compound.

2. The photosensitive adhesive resin composition according to claim 1, wherein the compound (A) is a (meth)acryloyl-modified novolac phenol resin.

3. The photosensitive adhesive resin composition according to claim 1, wherein the compound (A) is a (meth)acryloyl-modified bisphenol A shown by the following formula (1), 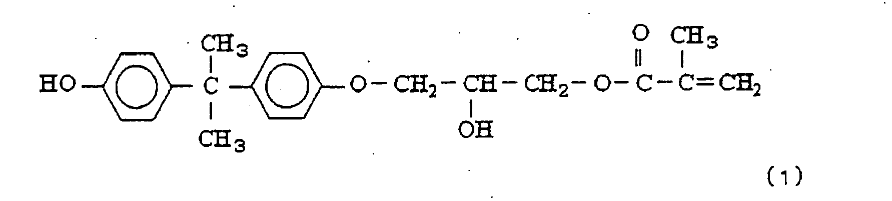 or 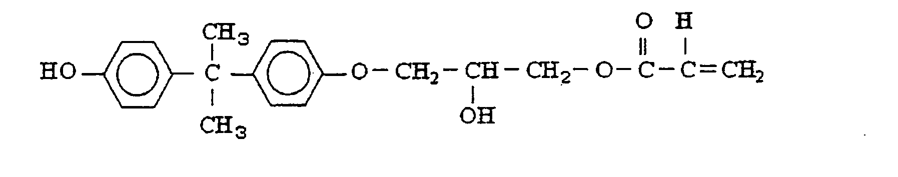 or a (meth)acryloyl-modified novolac bisphenol A resin obtained by substituting some of the hydroxyl groups of a novolac bisphenol A resin shown by the following formula (2) 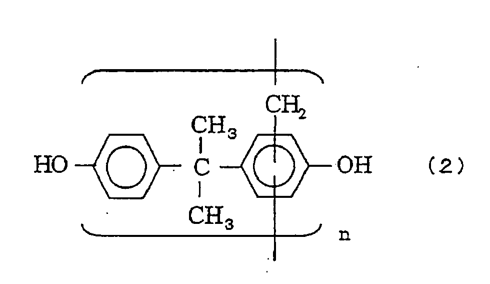 (wherein n is an integer from 2 to 15) with the group shown by the following formula (3).

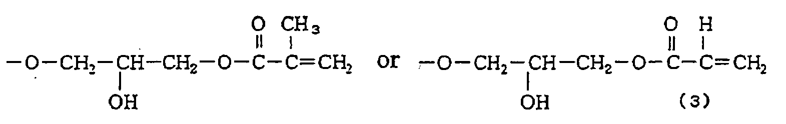

4. The photosensitive adhesive resin composition according to any one of claims 1 to 3, wherein the content of the phenol resin or the phenol compound (D) is 0.1 to 20 mass%.

5. The photosensitive adhesive resin composition according to any one of claims 1 to 4, wherein the phenol resin or the phenol compound (D) is a novolac phenol resin or phenol monomer.

6. The photosensitive adhesive resin composition according to any one of claims 1 to 5, further comprising a filler (F).

7. The photosensitive adhesive resin composition according to claim 6, wherein the content of the filler (F) is 3 to 50 mass%.

8. The photosensitive adhesive resin composition according to claim 6 or 7, wherein the average particle diameter of the filler (F) is 0.03 to 0.4 µm.

9. The photosensitive adhesive resin composition according to any one of claims 6 to 8, wherein the filler (F) is a silica filler.

10. The photosensitive adhesive resin composition according to any one of claims 1 to 9, wherein the resin (B) which cures with the compound (A) by thermal treatment is a combination of an epoxy resin which is solid at 25°C and a silicone-modified epoxy resin which is liquid at 25°C.

11. An adhesive film comprising a base film and an adhesive layer formed on the surface of the base film, the adhesive layer being formed of the photosensitive adhesive resin composition according to any one of claims 1 to 10.

12. A light-receiving device comprising a substrate on which a semiconductor element is formed, a transparent substrate facing the substrate, and a spacer formed between the transparent substrate and the substrate, the spacer being made of a cured material of the photosensitive adhesive resin composition according to any one of claims 1 to 11.
